# EUROPEAN PATENT APPLICATION

(11) **EP 2 787 539 A1**
(43) Date of publication of application: **08.10.2014**
(21) Application number: 11876755.7
(22) Date of filing: 30.11.2011
(51) Int. Cl.: H01L 31/042

(54) **PHOTOVOLTAIC MODULE AND METHOD FOR MANUFACTURING SAME**

(71) Applicant: Sanyo Electric Co., Ltd., Moriguchi-shi, Osaka 570-8677 (JP)
(72) Inventor: YOSHIMINE, Yukihiro, Moriguchi-shi Osaka 570-8677 (JP)
(74) Representative: Klunker . Schmitt-Nilson . Hirsch
(86) International application number: PCT/JP2011/077638
(87) International publication number: WO 2013/080324

(57) **Abstract**

A photovoltaic module (10) is provided with: photovoltaic elements (14), each of which has a light receiving surface-side electrode and a back surface-side electrode (26); and a connection member which is connected to the photovoltaic elements (14) with resin-containing adhesive layers (50, 52) respectively interposed therebetween. The width of the connection member facing the back surface-side electrode (26) is narrower than the width of the back surface-side electrode (26). The connection member has recesses and projections (40) on the surface facing the back surface-side electrode (26), and connects one photovoltaic element and another photovoltaic element (14) with each other, said photovoltaic elements being arranged adjacent to each other. The back surface-side electrode (26) is an electrode that covers generally all over the back surface of the photovoltaic element (14).

## Description

### Technical Field

The present invention relates to a photovoltaic module in which adj acent photovoltaic elements are connected by a connection member, and a manufacturing method thereof.

### Background Art

In a photovoltaic element which generates power by receiving solar light, an electrode for collecting electricity is provided on a surface which is called a primary surface, in order to extract electrical power from a photovoltaic unit which generates an electromotive force by receiving the solar light. In order to have a photovoltaic module by connecting a plurality of photovoltaic elements to each other, the electrodes of the adjacent photovoltaic elements are connected to each other by a connection member.

For example, Patent Document 1 discloses that, in a solar battery cell of related art, an electricity collecting electrode called a bus bar is provided on a surface, and a conductive memcalled a tab is soldered thereto. This document also describes that, in the soldering of the bus bar and the tab, there is a possible risk of cell division or electrode peeling. In consideration of such a risk, Patent Document 1 discloses that a plurality of fingers extending along one direction and arranged parallel to each other are provided on the primary surface, a soft conductor layer such as solder is provided on the surface of the tab, the tab is pressed onto the finger with an adhesive therebetween, and the finger is embedded in the soft conductor layer while the adhesive is discharged by flowing.

Patent Document 1 discloses in a fourth preferred embodiment in which heights of the fingers are set at two heights, and a difference between the two finger heights is smaller than a thickness of the soft conductor layer.

### [Related Art Reference]

### [Patent Document]

### [Patent Document 1] JP 2011-181963 A

### Disclosure of Invention

### [Technical Problem]

In order to mechanically and electrically connect the electrode of the photovoltaic element and the connection member using an adhesive such as a resin, it is necessary to suitably flow-discharge the adhesive between the electrode of the photovoltaic element and the connection member. In order to do so, the photovoltaic element and the connection member may be pressure-contacted. In this case, if an area where the connection member opposes the electrode of the photovoltaic element is too wide, the adhesive may be not adequately discharged by flowing. In particular, when the electrode on a back surface side of the photovoltaic element is set to have a wide area, there is a possibility that the adhesive may not be adequately discharged by flowing between the photovoltaic element and the connection member.

When the adhesive is not adequately discharged by flowing, the electrical connection between the electrode of the photovoltaic element and the connection member becomes insufficient, and the performance of the photovoltaic module may be degraded.

### [Solution to Problem]

According to one aspect of the present invention, there is provided a photovoltaic module comprising: a photovoltaic element having a light receiving surface-side electrode and a back surface-side electrode; and a connection member connected to the back surface-side electrode, wherein, in the connection member, a width of a portion opposing the back surface-side electrode is narrower than a width of the back surface-side electrode, and the connection member has unevenness formed on a surface opposing the back surface-side electrode.

### [Advantageous Effects of Invention]

According to the above-described structure, a connection member having the unevenness formed on the surface opposing the back surface of the photovoltaic element is employed. When the connection member is pressure-contacted with the photovoltaic element with adhesive therebetween, the adhesive between the back surface-side electrode of the photovoltaic element and the connection member can be suitably discharged by flowing, with the projections in the unevenness.

### Brief Description of Drawings

FIG. 1 is a diagram showing a structure of a photovoltaic module according to a preferred embodiment of the present invention.
FIG. 2 is a diagram enlarging and showing a cross section along a B-B line and a C-C line of FIG. 1.
FIG. 3 is a diagram showing another example connection member in a photovoltaic module according to a preferred embodiment of the present invention.
FIG. 4 is a diagram showing a connection member when an electrode surface has an uneven structure in a photovoltaic module according to a preferred embodiment of the present invention.

### Best Mode for Carrying Out the Invention

A preferred embodiment of the present invention will now be described in detail with reference to the drawings. In the following, an electrode having a bus bar and a finger will be described as a light receiving surface-side electrode of a photovoltaic element, but alternatively, the electrode may have only the finger. In the following, a square shape will be described as the planar shape of the photovoltaic element, but alternatively, the planar shape may be other shapes such as rectangular and circular.

A shape, a size, a number and a material of the electrode, or the like described in the following are merely exemplary for the purpose of the explanation, and may be suitably changed according to the specification of the photovoltaic element.

In the following, the same reference numerals will be assigned to the same elements among all drawings, and the elements will not be repeatedly described. In addition, in the description herein, reference numerals that are already described will be used as necessary.

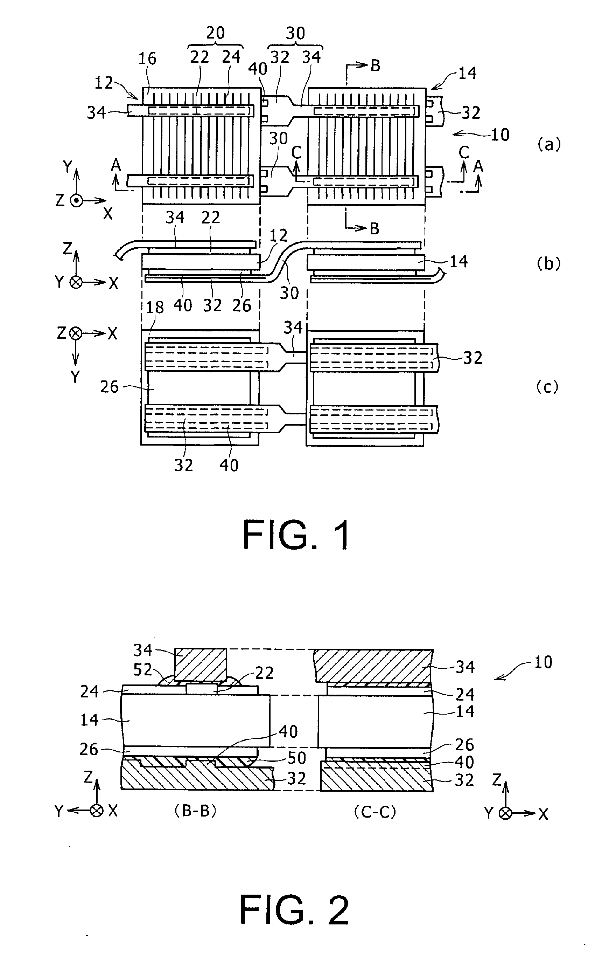

FIG. 1 is a diagram showing a structure of a photovoltaic module 10. In the photovoltaic module 10, a plurality of photovoltaic elements are connected to each other by a connection member 30, and a desired electrical power is obtained. In FIG. 1, of the plurality of photovoltaic elements connected by the connection member 30, two adjacent photovoltaic elements 12 and 14 are shown. FIG. 1(a) is a plan view. FIG. 1(b) is a cross sectional diagram along an A-A line of FIG. 1(a). FIG. 1(c) is a back side diagram. In these drawings, X, Y, and Z directions are respectively shown. The X direction is a direction of extension of the connection member 30, the Z direction is a thickness direction of the photovoltaic elements 12 and 14, and the Y direction is a direction orthogonal to the X and Z directions. In the drawings, a direction perpendicular to the page is indicated with an arrow indicating the direction. A side of the root of the arrow is shown with an X mark, and a side of the tip of the arrow is shown with a black circle.

The photovoltaic elements 12 and 14 have an approximate square planar shape, and an electricity collecting electrode is provided on a surface called a primary surface. Here, a light receiving surface-side electrode 20 and a back surface-side electrode 26 are provided. The photovoltaic elements 12 and 14 generate power by receiving light from the light receiving surface side, and the generated power is extracted by the light receiving surface-side electrode 20 and the back surface-side electrode 26. The electrode 20 is partially provided on the light receiving surface such that the photovoltaic elements 12 and 14 can receive the light. The electrode 26 is provided over approximately the entire surface of the back surfaces of the photovoltaic elements 12 and 14. The electrode 26 also serves as a reflection layer which reflects the light transmitting through the photovoltaic elements 12 and 14 toward the side of the photovoltaic elements 12 and 14. Therefore, the photovoltaic elements 12 and 14 are one side-type solar cells that generate power primarily using the light incident from the light receiving surface side.

The light receiving surface-side electrode 20 is made of two bus bars 22 having a relatively wide width and extending in a linear shape, and a plurality of fingers 24 connected to the bus bars 22. The fingers 24 are a plurality of electrodes which extend in a direction intersecting a direction of extension of the bus bar 22 and which are placed parallel to each other. A width size of the finger 24 is set narrower than a width size of the bus bar 22. In place of this, a larger number of fingers 24 may be provided over the entire surface of the light receiving surface than over the bus bar 22 in an approximately uniform line density. Therefore, the electrical power generated by the photovoltaic elements 12 and 14 is approximately uniformly extracted by the fingers 24 from different locations of the light receiving surface and is collected to the bus bars 22.

The bus bar 22 and the finger 24 can be formed by screen-printing a conductive paste in a predetermined pattern, and then curing or baking the conductive paste. Alternatively, the bus bar 22 and the finger 24 may be formed through other methods such as plating, deposition, sputtering, or the like. With regard to a height from the primary surface, the height of the bus bar 22 is preferably set slightly higher. Alternatively, another conductive layer such as a solder layer may be provided on a conductive layer.

The back surface-side electrode 26 is an electrode which covers approximately the entirety of the back surfaces of the photovoltaic elements 12 and 14. Here, covering approximately the entirety means that, for example, in the case of the photovoltaic elements 12 and 14 having an approximately square planar shape, the planar shape of the back surface-side electrode 26 is set to an approximately square shape obtained by removing a peripheral margin size from the planar size of the photovoltaic elements 12 and 14. By securing the margin size, disadvantages such as occurrence of undesired leakage through the electrode 26 can be inhibited.

The back surface-side electrode 26 can also be formed by screen-printing a conductive paste in an approximately square pattern and then curing or baking the conductive paste. Alternatively, the back surface-side electrode 26 may be formed by covering a peripheral portion on the back surfaces of the photovoltaic elements 12 and 14 with a mask, and then applying sputtering or deposition. Alternatively, another conductive layer such as a solder layer may be provided on a conductive layer.

The connection member 30 is a conductive member which connects together one photovoltaic element 12 and another photovoltaic element 14, which are placed adjacently. Details of the connection between the connection member 30 and the photovoltaic elements 12 and 14 will be described later. The connection member 30 includes a back surface-side connection portion 32 connected to the back surface-side electrodes 26 of the photovoltaic elements 12 and 14, and a light receiving surface-side connection portion 34 connected to the bus bar 22 on the light receiving surface side. In the example structure of FIG. 1, two connection members 30 are used to connect adjacent photovoltaic elements 12 and 14 to each other, but this structure is merely exemplary. The number of connection members 30 may be arbitrarily set according to the specification of the photovoltaic module 10. For example, the number of connection members 30 may be one, or three or more.

The light receiving surface-side connection portion 34 has a larger width size (size in a direction orthogonal to the direction of extension) than a width size of the bus bar 22.

The back surface-side connection portion 32 has a width size covering a part of the back surface-side electrode 26. Therefore, an area where the back surface-side connection portion 32 opposes the back surface-side electrode 26 is set narrower than an area of the back surface-side electrode 26. In this manner, a size relationship between the area where the connection member 30 opposes the electrode and the area of the electrode to be connected differs between the light receiving surface-side connection portion 34 and the back surface-side connection portion 32.

The width size of the portion opposing the back surface-side electrode 26 in the back surface-side connection portion 32 is set larger than the width size of the portion opposing the light receiving surface-side bus bar 22 in the light receiving surface-side connection portion 34. In other words, the area opposing the back surface-side electrode 26 in the back surface-side connection portion 32 is larger than the area of the portion opposing the light receiving surface-side bus bar 22 in the light receiving surface-side connection portion 34. With such a configuration, the electrical power can be collected from a wide range of the back surface-side electrode 26 covering the entirety of the back surfaces of the photovoltaic elements 12 and 14 to the back surface-side connection portion 32, and extracted.

On the surface of the back surface-side connection portion 32 opposing the back surface-side electrode 26, unevenness 40 (projections and recesses) is provided. The unevenness 40 is formed by forming projections on the back surface-side connection portion 32. The projections form a projected portion of the unevenness 40, and a portion where the projections are not formed is a recessed portion of the unevenness 40. The unevenness 40 is provided in order to achieve a superior connection between the connection member 30 and the photovoltaic elements 12 and 14. In FIG. 1, as the unevenness 40, projections parallel to the direction of extension of the connection member 30 are provided. The unevenness 40 can be obtained by press-machining or partial etching-machining the connection member 30, or by integrating a thin plate which forms the projection on a thin sheet having a flat plate shape by a method such as adhesion.

A method of manufacturing the photovoltaic module 10 includes a connection step to connect to the back surface-side electrodes 26 of the photovoltaic elements 12 and 14. The connection step includes a step of preparing the connection member 30 having unevenness on at least one surface thereof, a step of placing the connection member 30 on the back surface-side electrode 26 with an adhesive therebetween and with the unevenness oriented toward the back surface-side electrode 26, and a step of pressure-contacting the connection member 30 and the back surface-side electrode 26 while the adhesive is flow-discharged from between a projection of the unevenness and the back surface-side electrode 26. The connection between the connection member 30 and the photovoltaic elements 12 and 14 will now be described with reference to FIG. 2.

FIG. 2 is a diagram showing, in comparison with each other, a partially enlarged view of a cross section along a B-B line in FIG. 1 and a partially enlarged view of a cross section along a C-C line in FIG. 1. The cross sectional diagram along the B-B line is a plane parallel to the XZ plane, and the cross sectional diagram along the C-C line is a cross sectional diagram along the XZ plane.

The connection member 30 is adhered to the photovoltaic element 14 by an adhesive layer including a resin. Specifically, an adhesive layer 50 including a resin is placed between the back surface-side electrode 26 of the photovoltaic element 14 and the back surface-side connection portion 34 of the connection member. With the resin included in the adhesive layer 50, the back surface-side electrode 26 and the back surface-side connection portion 32 of the connection member 30 are adhered. In addition, another adhesive layer 52 including a resin is placed between the light receiving surface-side electrode 20 (bus bar 22) of the photovoltaic element 14 and the light receiving surface-side connection portion 34 of another connection member 30. With the resin included in the adhesive layer 52, the light receiving surface-side electrode 20 (bus bar 22) and the light receiving surface-side connection portion 34 are adhered.

As the adhesives forming the adhesive layers 50 and 52, for example, an adhesive having, as the primary composition, a resin which can adhere at a temperature of 200 °C or less may be used. As such an adhesive, for example, in addition to an adhesive having an epoxy-based resin as the primary composition, an adhesive having an acryl-based resin as the primary composition, an adhesive having an urethane-based resin as the primary composition, or the like may be used.

As the adhesives for forming the adhesive layers 50 and 52, a resin-type adhesive having an anisotropic conductivity or an insulating adhesive may be preferably used. Because these adhesives include a large amount of the resin composition, the adhesion strength can be increased.

The adhesive for forming the adhesive layer 50 and the adhesive for forming the adhesive layer 52 may be the same or different from each other. Alternatively, a film-form adhesive may be used or a paste-form adhesive may be used.

Because the adhesives forming the adhesive layers 50 and 52 include a large amount of the resin composition, preferably, the adhesive is appropriately discharged by flowing from the region between the connection member 30 and the bus bar 22 and from the region between the connection member 30 and the back surface-side electrode 26. The meaning of "appropriate" is that the connection member 30 and the bus bar 22 or the connection member 30 and the back surface-side electrode 26 are electrically connected while the mechanical connection is maintained. For example, with regard to the photovoltaic element 14, while the photovoltaic element 14 is sandwiched between the light receiving surface-side connection portion 34 and the back surface-side connection portion 32 of the connection member 30, the photovoltaic element 14 is pressure-contacted from both sides at an appropriate pressure. By applying an appropriate temperature treatment, the adhesion is executed. The appropriate pressure and the appropriate temperature treatment are set such that both the electrical connection and the mechanical connection satisfy a predetermined condition.

In the region between the light receiving surface-side connection portion 34 and the bus bar 22, the adhesive is appropriately discharged by flowing from the region between the portion of the light receiving surface-side connection portion 34 opposing the bus bar 22 and the bus bar 22, and the adhesive layer 52 is formed by the appropriate temperature treatment. By the flow-discharge, the electrical connection between the light receiving surface-side connection portion 34 and the bus bar 22 is maintained. With regard to the flow-discharged adhesive, because the width of the portion of the light receiving surface-side connection portion 34 opposing the bus bar 22 is larger than the width of the bus bar 22, the portion of the difference is used for the mechanical adhesion. In this manner, the light receiving surface-side connection portion 34 and the bus bar 22 are mechanically connected and also electrically connected.

Between the back surface-side connection portion 32 and the back surface-side electrode 26, because the unevenness 40 is provided on the back surface-side connection portion 32, the adhesive is appropriately discharged by flowing from a region between the portion of the back surface-side connection portion 32 opposing the back surface-side electrode 26 and the projection of the unevenness 40, to form the adhesive layer 50. With the flow-discharge, the electrical connection between the back surface-side connection portion 32 and the back surface-side electrode 26 is maintained. The flow-discharged adhesive flows into the recess of the unevenness 40, and thus, the adhesive layer 50 formed in the recess is primarily used for the mechanical adhesion. In this manner, the back surface-side connection portion 32 and the back surface-side electrode 26 are mechanically connected and also electrically connected.

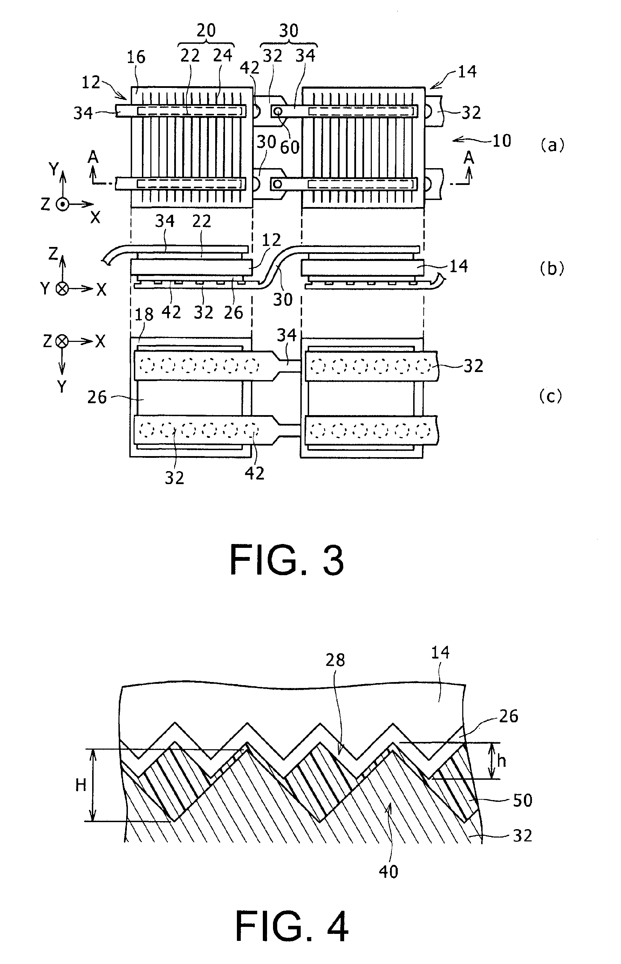

FIG. 3 is a diagram showing a structure in which separate members are employed for the light receiving surface-side connection portion 34 and the back surface-side connection portion 32 of the connection member 30, and the connection portions are integrated by a suitable connection means 60 such as a caulking pad or the like.

FIG. 3 also shows an example of unevenness 42 provided in a discrete manner. In FIGs. 1 and 2, the unevenness 40 is an extending projection, but the unevenness 42 is formed by projections placed apart from each other. The shape of the unevenness 42 may be a projection having a trapezoidal cross sectional shape, a projection having a semispherical cross sectional shape, or a projection having a sawtooth-like cross sectional shape. For the placement in the case of the projection having the sawtooth-like cross sectional shape, the sawtooth-like shape may be repeated in the direction of extension of the connection member 30. In addition, the discrete placement of the unevenness 42 may be a two-dimensional placement.

With regard to the structure which uses the connection means 60 and the structure which uses the discrete placement unevenness 42, one of these structures may be employed as a replacement in the structures shown in FIGs. 1 and 2.

FIG. 4 is a diagram showing a relationship between a height h of unevenness of an uneven structure and a height H of the unevenness 40 of the back surface-side connection portion 32 when the uneven structure 28 corresponding to a texture structure formed on the back surface of the photovoltaic element 14 is provided on the surface of the back surface-side electrode 26 opposing the back surface-side connection portion 32 of the connection member 30. As shown in FIG. 4, the height H of the unevenness 40 of the back surface-side connection portion 32 is set higher than the height h of the unevenness of the uneven structure 28 on the back surface-side electrode 28. With such a configuration, by the projection of the unevenness 40 of the back surface-side connection portion 32, the adhesive is appropriately discharged by flowing, between the back surface-side connection portion 32 and the uneven structure 28 of the back surface-side electrode 26, and the adhesive flows into the recess of the unevenness 40.

### [Industrial Applicability]

A photovoltaic module according to the present invention can be used as a self-sustaining power source.

### [Explanation of Reference Numerals]

10 PHOTOVOLTAIC MODULE; 12, 14 PHOTOVOLTAIC ELEMENT; 20 LIGHT RECEIVING SURFACE-SIDE ELECTRODE; 22 BUS BAR; 24 FINGER; 26 BACK SURFACE-SIDE ELECTRODE; 28 UNEVENNESS STRUCTURE; 30 CONNECTION MEMBER; 32 BACK SURFACE-SIDE CONNECTION PORTION; 34 LIGHT RECEIVING SURFACE-SIDE CONNECTION PORTION; 40, 42 UNEVENNESS; 50, 52 ADHESIVE LAYER; 60 CONNECTION MEANS.

## Claims

1. A photovoltaic module comprising:
a photovoltaic element having a light receiving surface-side electrode and a back surface-side electrode; and
a connection member connected to the back surface-side electrode, wherein
in the connection member, a width of a portion opposing the back surface-side electrode is narrower than a width of the back surface-side electrode, and the connection member has unevenness formed on a surface opposing the back surface-side electrode.

2. The photovoltaic module according to Claim 1, further comprising:
an adhesive layer between the connection member and the back surface-side electrode, wherein
the adhesive layer includes a resin.

3. The photovoltaic module according to Claim 1 or 2, wherein
the back surface-side electrode covers approximately an entirety of a back surface of the photovoltaic element.

4. The photovoltaic module according to Claim 3, wherein
the back surface-side electrode is a reflective layer.

5. The photovoltaic module according to any one of Claims 1 - 4, further comprising:
another connection member connected to the light receiving surface-side electrode of the photovoltaic element, wherein
a width of a portion of the connection member opposing the back surface-side electrode is wider than a width of the other connection member opposing the light receiving surface-side electrode.

6. The photovoltaic module according to Claim 5, further comprising:
another adhesive layer between the other connection member and the back surface-side electrode, wherein
the other adhesive layer includes a resin.

7. The photovoltaic module according to any one of Claims 1 - 6, wherein
the back surface-side electrode has an uneven structure on a surface opposing the connection member, and
a height of the unevenness of the connection member is higher than an unevenness height of the unevenness of the back surface-side electrode.

8. A method of manufacturing a photovoltaic module, comprising:
a connection step to connect to a back surface-side electrode of a photovoltaic element, wherein
the connection step comprises:
a step of preparing the connection member having unevenness on at least one surface thereof;
a step of placing the connection member on the back surface-side electrode with an adhesive therebetween and with the unevenness oriented toward the back surface-side electrode, and
a step of pressure-contacting the connection member and the back surface-side electrode while flow-discharging the adhesive from a region between a projection of the unevenness and the back surface-side electrode.
